# EUROPEAN PATENT APPLICATION

(11) **EP 4 600 762 A1**
(43) Date of publication of application: **13.08.2025**
(21) Application number: 24852987.7
(22) Date of filing: 09.08.2024
(51) Int. Cl.: G04G 17/04, G04G 17/06, H05K 1/02

(54) **WEARABLE DEVICE**

(30) Priority: 29.12.2023 CN 202311841643
(71) Applicant: Honor Device Co., Ltd., Shenzhen, Guangdong 518040 (CN)
(72) Inventor: BAI, Liang, Shenzhen, Guangdong 518040 (CN); SU, Yangquan, Shenzhen, Guangdong 518040 (CN)
(74) Representative: Gill Jennings & Every LLP
(86) International application number: PCT/CN2024/111007
(87) International publication number: WO 2025/138845

(57) **Abstract**

This application provides a wearable device, including a housing, a first circuit board, a second circuit board, a flexible circuit board, and a first support member. The housing is provided with a first cavity and a second cavity. The first circuit board is disposed in the first cavity. The second circuit board is disposed in the second cavity and provided with a first connection portion. The flexible circuit board is provided with a second connection portion. The first support member is connected between the first connection portion and the second connection portion, so that the second circuit board and the flexible circuit board are electrically conductive and have a spacing in an arrangement direction of the second cavity and the first cavity. In the foregoing wearable device, the flexible circuit board is supported by the first support member in a direction of the second cavity toward the first cavity, so that a position of a first flexible circuit board located in the first cavity is lifted up or a position of a first flexible circuit board in the second cavity is lifted up, thereby avoiding a wall-climbing problem of the flexible circuit board or reducing a wall-climbing height of the flexible circuit board extending from the second cavity to the first cavity.

## Description

### CROSS-REFERENCE TO RELATED APPLICATIONS

This application claims priority to Chinese Patent Application No. 202311841643.4, filed with the China National Intellectual Property Administration on December 29, 2023 and entitled "WEARABLE DEVICE", which is incorporated herein by reference in its entirety.

### TECHNICAL FIELD

Embodiments of this application relate to the field of terminal technologies, and in particular, to a wearable device.

### BACKGROUND

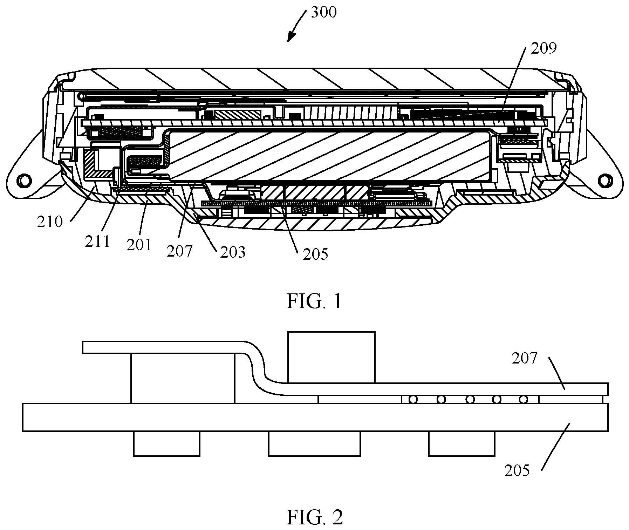

A wearable device 200 such as a watch is shown in FIG. 1 and FIG. 2. To implement miniaturization, a housing 201 part of the wearable device 200 is provided with a protrusion 203, to accommodate structures such as a charging adsorption magnet, a photoplethysmography (Photoplethysmography, PPG) module, and an electrocardiogram (electrocardiogram, ECG) module. Circuits of these structures are integrated and connected to a circuit board 205. The circuit board 205 is connected to a flexible circuit board 207 in the protrusion 203, and then extends to the outside of the protrusion 203 through the flexible circuit board 207 to be connected to a main board 209 of the device, to implement a signal connection between the circuit board 205 and the main board 209. Due to limitation of a relatively small space of the protrusion 203 on the housing, the flexible circuit board 207 is usually connected to the circuit board 205 in a welding manner such as laser beam welding or hotbar (Hotbar) soldering. However, when the flexible circuit board 207 extends from the protrusion 203 to a peripheral side of the protrusion 203, a size difference exists in an arrangement direction. This causes a wall-climbing problem of the flexible circuit board 207 and a risk of unreliable soldering.

### SUMMARY

In view of this, this application provides a wearable device for reducing a wall-climbing height of a flexible circuit board.

This application provides a wearable device. The wearable device includes a housing, a first circuit board, a second circuit board, a flexible circuit board, and a first support member. The housing is provided with a first cavity and a second cavity that are arranged in sequence and communicate with each other. The first circuit board is disposed in the first cavity. The second circuit board is disposed in the second cavity and provided with a first connection portion. The flexible circuit board is connected to and electrically conductive to the first circuit board. The flexible circuit board is provided with a second connection portion. The first support member is connected between the first connection portion and the second connection portion, so that the second circuit board and the flexible circuit board are electrically conductive and have a spacing in an arrangement direction of the second cavity and the first cavity.

In the foregoing wearable device, the flexible circuit board and the second circuit board have the spacing in the arrangement direction of the first cavity and the second cavity by using the first support member. The flexible circuit board is supported by the first support member in a direction of the second cavity toward the first cavity, so that a position of a first flexible circuit board located in the first cavity is lifted up or a position of a first flexible circuit board in the second cavity is lifted up. When the first flexible circuit board is located in the first cavity, a slope-climbing section is not needed on the flexible circuit board when the flexible circuit board extends from the second cavity to the first cavity and crosses a junction between the first cavity and the second cavity, thereby avoiding a wall-climbing problem of the flexible circuit board. When the second connection portion of the flexible circuit board is located in the second cavity, a spacing between the flexible circuit board and the junction between the first cavity and the second cavity is reduced, thereby reducing a wall-climbing height at which the flexible circuit board extends from the second cavity to the first cavity.

In a possible implementation, the wearable device further includes a plurality of first elements. The plurality of first elements are separately connected to a side that is of the flexible circuit board and that faces the second circuit board.

In the foregoing implementation, the plurality of first elements are separately connected to the flexible circuit board and are located on a side that is of the flexible circuit board and that faces the second circuit board. The plurality of first elements can use space in the second cavity to reduce or avoid a case in which the plurality of first elements on the flexible circuit board occupy space in the first cavity, thereby avoiding an increase of an overall size of the wearable device in the arrangement direction.

In a possible implementation, the wearable device further includes a plurality of second elements. The plurality of second elements are separately connected to a side that is of the second circuit board and that faces the flexible circuit board.

In the foregoing implementation, the plurality of first elements and the plurality of second elements are disposed in a space formed between the flexible circuit board and the second circuit board that are supported by the first support member, to reduce a space occupied in the first cavity in the arrangement direction, thereby effectively reducing a size of the wearable device in the arrangement direction.

In a possible implementation, the spacing between the flexible circuit board and the second circuit board in the arrangement direction is less than a sum of a maximum size of the plurality of first elements in the arrangement direction and a minimum size of the plurality of second elements in the arrangement direction; and/or the spacing between the flexible circuit board and the second circuit board in the arrangement direction is less than a sum of a minimum size of the plurality of first elements in the arrangement direction and a maximum size of the plurality of second elements in the arrangement direction; and/or when a sum of sizes of the first element and the second element in the arrangement direction is less than the spacing between the flexible circuit board and the second circuit board, projections of the first element and the second element on the second circuit board in the arrangement direction intersect.

In the foregoing implementation, the spacing between the flexible circuit board and the second circuit board is less than the sum of the maximum size of the plurality of first elements in the arrangement direction and the minimum size of the plurality of second elements in the arrangement direction, or less than the sum of the minimum size of the plurality of first elements in the arrangement direction and the maximum size of the plurality of second elements in the arrangement direction. In this way, the first element or the second element having the maximum size in the arrangement direction does not use a superposition element arrangement form in the arrangement direction, so that the spacing between the flexible circuit board and the second circuit board is as small as possible, thereby facilitating reduction of a size of the wearable device in the arrangement direction. When sizes of the first element and the second element in the arrangement direction are less than the spacing between the flexible circuit board and the second circuit board, a superposition arrangement form is used to reduce an occupied area in a plane perpendicular to a thickness space, thereby fully using a space of the second circuit board and the flexible circuit board in the arrangement direction.

In a possible implementation, the wearable device further includes a connection piece. The connection piece is bonded between the first element and the second element; and/or the connection piece is bonded between the first element and the second circuit board; and/or the connection piece is bonded between the second element and the flexible circuit board.

In the foregoing implementation, the flexible circuit board and a second connection piece are connected by using a connection piece, to improve connection reliability and reduce a motion amount of the flexible circuit board.

In a possible implementation, the flexible circuit board includes a first section and a second section that are connected in sequence. The second section extends toward a side of the first section, so that the second section is connected to the first circuit board. The second connection portion is disposed on the first section. The first section is flat.

In the foregoing implementation, the first section is flat, to avoid a wall-climbing problem caused due to bent extension of the first section between the first cavity and the second cavity. The first section of the flexible circuit board is flat, thereby facilitating reduction of a space occupied by the first section of the flexible circuit board on a side that is of a battery and that is away from the first circuit board in the arrangement direction.

In a possible implementation, the wearable device further includes a battery. The battery is disposed in the first cavity and is located between the first circuit board and the second circuit board. A side that is of the flexible circuit board and that faces away from the plurality of first elements faces the battery.

In the foregoing implementation, the plurality of first elements are separated from the battery by the flexible circuit board, to avoid damage caused due to collision with the battery when the first elements are separated from the flexible circuit board by external force, thereby protecting the battery and the first elements and improving safety of the battery.

In a possible implementation, the flexible circuit board further includes a plurality of fourth sections. The fourth sections are connected to the first section and separately extend to a peripheral side of the second cavity. The wearable device further includes a plurality of third elements. The plurality of third elements are separately disposed in the first cavity and are located on an outer peripheral side of the second cavity. Each fourth section is connected to one third element.

In the foregoing implementation, the first support member elevates a position of the flexible circuit board relative to the second cavity in the arrangement direction, to reduce a wall-climbing height of the fourth section of the flexible circuit board connected to the third element and reduce a motion range of the fourth section, thereby reducing risks such as wrinkling caused due to motion of the fourth section under force.

In a possible implementation, the first support member extends in the arrangement direction and is perpendicular to the first connection portion and the second connection portion.

In the foregoing implementation, the first support member extends in the arrangement direction and is perpendicular to the first connection portion and the second connection portion, to reduce an occupied area of the first support member in a plane perpendicular to the arrangement direction, thereby increasing an element arrangement space between the second circuit board and the flexible circuit board.

In a possible implementation, the wearable device further includes a charging coil. The charging coil is located in the second cavity, surrounds an outer periphery of the plurality of first elements, and is connected to the second circuit board.

In the foregoing implementation, the charging coil is located in the second cavity, and a size of the second circuit board is reduced, so that a space for accommodating the charging coil is reserved in the second cavity. The charging coil does not occupy a size of the first cavity. In other words, the charging coil does not increase the size of the first cavity in the arrangement direction, thereby reducing visual heaviness of the wearable device.

In a possible implementation, the wearable device further includes a magnet. The magnet is disposed on the second circuit board and is located in the second cavity. The magnet is configured to absorb a charging device.

In the foregoing implementation, the magnet can position the wearable device on the charging device, so that charging efficiency can be improved through cooperation between the charging coil of the wearable device and a coil of the charging device.

In a possible implementation, the wearable device further includes a second support member. The second support member is connected to the flexible circuit board or the second circuit board and is supported between the flexible circuit board and the second circuit board. The second support member and the first support member are spaced and are separately near an edge of the second circuit board.

In the foregoing implementation, the first support member and the second support member are spaced and supported between the second circuit board and the flexible circuit board, to provide support force for the flexible circuit board and the second circuit board under external force, thereby improving space stability between the flexible circuit board and the second circuit board and improving reliability of disposing the plurality of first elements and the plurality of second elements in the space.

In a possible implementation, a plurality of pads are separately disposed on two sides of the first support member. Projections of the plurality of pads on the second circuit board in the arrangement direction are near an edge of the second circuit board. The plurality of pads are separately soldered to the second connection portion and the second circuit board.

In the foregoing implementation, when there is no wall-climbing section of the flexible circuit board near the second connection portion, the projections of the plurality of pads on the second circuit board in the arrangement direction can be positions laid near the edge of the second circuit board, to improve density of soldering positions laid on the second circuit board, thereby facilitating reduction of a size of the second circuit board.

### BRIEF DESCRIPTION OF DRAWINGS

FIG. 1 is a cross-sectional view of a wearable device in conventional technologies;
FIG. 2 is a local diagram of soldering a structure located in a protrusion to a flexible circuit board in the wearable device shown in FIG. 1;
FIG. 3 is a local top view of a circuit board and the flexible circuit board shown in FIG. 2;
FIG. 4 is a local sectional view of a wearable device according to an embodiment of this application;
FIG. 5 is a diagram of assembling a flexible circuit board, a second circuit board, a first support member, a second support member, a first element, and a second element in the wearable device shown in FIG. 4;
FIG. 6 is a local diagram of soldering a structure located in a second cavity to a flexible circuit board in the wearable device shown in FIG. 4;
FIG. 7 is a local diagram of the wearable device shown in FIG. 6 according to another embodiment;
FIG. 8 is a local diagram of the wearable device shown in FIG. 6 according to still another embodiment;
FIG. 9 is a diagram in which a flexible circuit board is provided with a first accommodating hole in the wearable device shown in FIG. 6 according to another embodiment;
FIG. 10 is a diagram in which a second circuit board is provided with a second accommodating hole in the wearable device shown in FIG. 6 according to another embodiment;
FIG. 11 is a diagram of projections of first elements and second elements on a second circuit board in the wearable device shown in FIG. 6; and
FIG. 12 is a local diagram in which the wearable device shown in FIG. 4 is located on a side of a battery when a third section of a flexible circuit board is omitted in another embodiment.

### Reference numerals of main components

Wearable device: 100, 200; housing: 10, 201; first cavity: 101; cavity wall: 1011; second cavity: 103; first shell: 11; second shell: 12; screen: 13; junction: 1001; first circuit board: 20; second circuit board: 30; first connection portion: 31; second accommodating hole: 301; flexible circuit board: 40, 207; second connection portion: 401; first section: 41; second section: 43; third section: 45; fourth section: 47; first accommodating hole: 403; first support member: 51; pad: 511; soldering hole: 513, 513a; second support member: 53; first element: 61; second element: 62; third element: 63; connection piece: 70; battery: 80; charging coil: 91, 211; magnet: 93; circuit board: 205; protrusion: 203; main board: 209; middle shell: 210; arrangement direction: Z.

This application is further described in the following specific embodiments with reference to the accompanying drawings.

### DESCRIPTION OF EMBODIMENTS

To further describe technical means and effects that are used in this application to achieve a predetermined application objective, description is provided below with reference to the accompanying drawings and embodiments. It is clear that the described embodiments are merely some but not all of embodiments of this application.

Unless otherwise defined, all technical and scientific terms used in this specification have the same meanings as those usually understood by a person skilled in the art of this application. The terms used in the specification of this application are merely for the purpose of describing specific embodiments, and are not intended to limit this application.

Some implementations of this application provide a wearable device. The wearable device includes a housing, a first circuit board, a second circuit board, a flexible circuit board, and a first support member. The housing is provided with a first cavity and a second cavity that are disposed in sequence in an arrangement direction and communicate with each other. The first circuit board is disposed in the first cavity. The second circuit board is disposed in the second cavity. The flexible circuit board is configured to connect the first circuit board and the second circuit board. The flexible circuit board is provided with a second connection portion. The first support member is connected between the second connection portion and the second circuit board in the arrangement direction.

In the foregoing wearable device, the first support member enables the first flexible circuit board to be electrically connected to the second circuit board in the first cavity, the second connection portion that is of the flexible circuit board and that is connected to the second circuit board in the second cavity is not located in the second cavity, and when the flexible circuit board is connected to the first circuit board in the first cavity, a slope-climbing section is not needed when the flexible circuit board extends from the second cavity to the first cavity, thereby avoiding a wall-climbing problem of the flexible circuit board. Alternatively, a distance between the second connection portion of the flexible circuit board and a cavity wall of the first cavity toward the second cavity is reduced by using the first support member, thereby reducing a wall-climbing height of the flexible circuit board extending from the second cavity to the first cavity.

The following describes in detail some embodiments of this application with reference to the accompanying drawings. In absence of conflicts, the following embodiments and features in the embodiments may be combined.

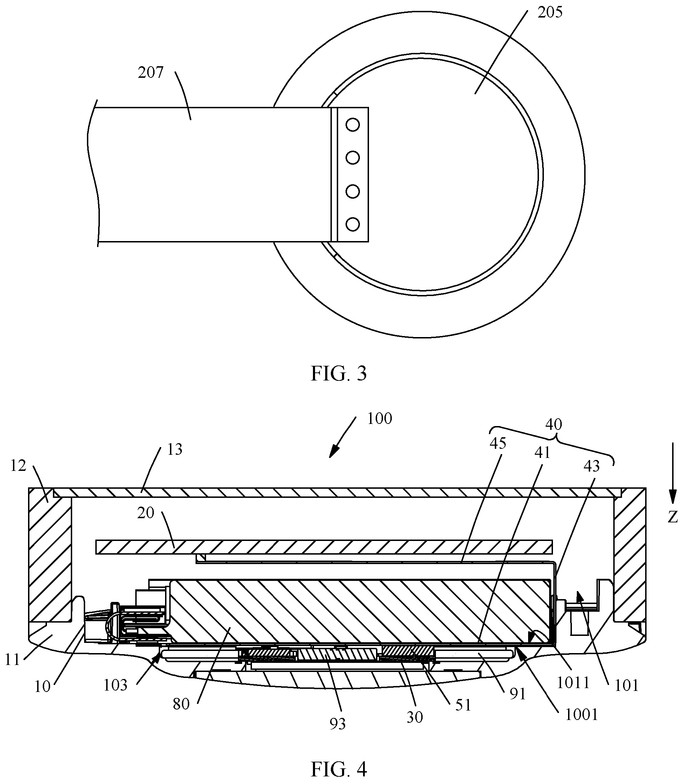

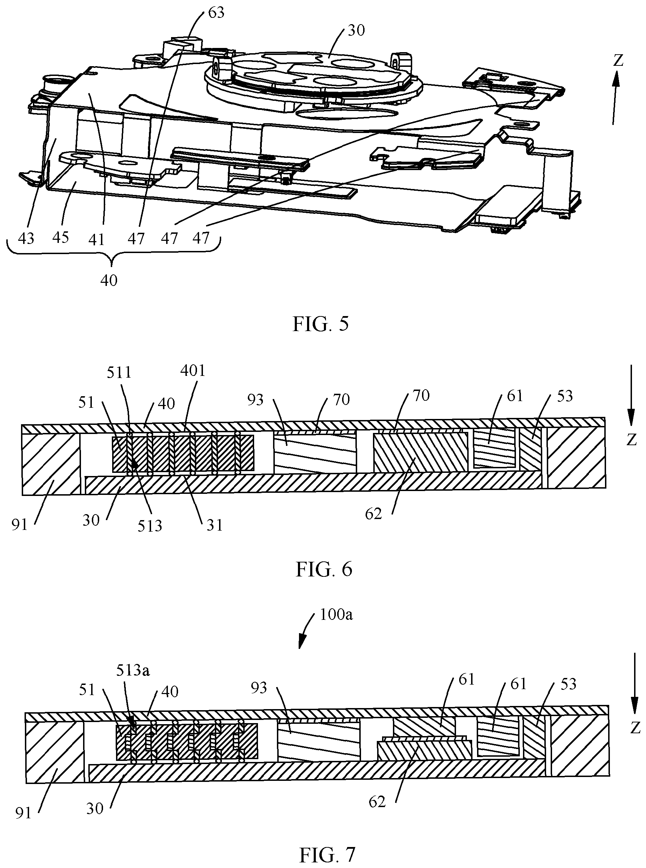

With reference to both FIG. 4 and FIG. 5, an embodiment of this application provides a wearable device 100. In an embodiment, the wearable device 100 is a watch worn on a wrist. However, this is not limited thereto. For example, in another embodiment, the wearable device 100 may alternatively be a structure that is worn on a human body or an animal body such as finger, ankle, arm, leg, or face, for example, a monitor, a headset, a bracelet, a ring, or VR glasses.

The wearable device 100 includes a housing 10, a first circuit board 20, a second circuit board 30, a flexible circuit board 40, and a first support member 51. The housing 10 is provided with a first cavity 101 and a second cavity 103 that are arranged in sequence and communicate with each other. For ease of subsequent description, the arrangement direction of the first cavity 101 and the second cavity 103 is set to an arrangement direction Z. The arrangement direction Z may be a horizontal direction, a vertical direction, or a direction inclined relative to the horizontal direction and the vertical direction. The arrangement direction Z is an arrangement setting of the first cavity 101 and the second cavity 103 in the housing 10, and is irrelevant to a reference such as a horizontal plane or a vertical plane outside the housing 10. The second circuit board 30 is disposed in the second cavity 103. The first circuit board 20 is disposed in the first cavity 101. The first circuit board 20 is connected to the second circuit board 30 by using the flexible circuit board 40, to implement electrical signal conduction. The first circuit board 20 is a main board 209 of the wearable device 100. A circuit of at least one element of a PPG, an ECG, and the like is integrated into the second circuit board 30. The flexible circuit board 40 communicatively connects the circuit of the at least one element of the PPG, the ECG, and the like to the main board 209.

In an embodiment, the housing 10 includes a first shell 11, a second shell 12, and a screen 13. The first shell 11 and the screen 13 are respectively connected to two opposite sides of the second shell 12. The first shell 11, the second shell 12, and the screen 13 enclose a cavity. A part of the first shell 11 is recessed in a direction away from the screen 13 to form the second cavity 103. A space in the cavity except the second cavity 103 is the first cavity 101. The first shell 11 is located at an outer peripheral part of a junction 1001 between the first cavity 101 and the second cavity 103, to form a cavity wall 1011 of the first cavity 101. The second cavity 103 is equivalent to a recess on the cavity wall 1011 of the first cavity 101.

It may be understood that, in another embodiment, the first shell 11 and the second shell 12 may alternatively be an integrated structure. Alternatively, in another embodiment, for example, when the wearable device is a headset without a screen, the screen 13 may be omitted, and the first shell 11 and the second shell 12 form a space that includes the first cavity 101 and the second cavity 103. A specific structure of the housing 10 is not limited, provided that the first cavity 101 and the second cavity 103 that are arranged in sequence and communicate with each other are formed in the housing 10.

Further with reference to FIG. 6, the second circuit board 30 is provided with a first connection portion 31. The flexible circuit board 40 is provided with a second connection portion 401. The first support member 51 is connected between the first connection portion 31 and the second connection portion 401, so that the flexible circuit board 40 and the second circuit board 30 are electrically conductive, and the flexible circuit board 40 and the second circuit board 30 have a spacing in the arrangement direction Z.

In an embodiment, an arrangement direction of the first connection portion 31 and the second connection portion 401 is parallel to the arrangement direction Z, and the first support member 51 extends in the arrangement direction Z perpendicular to the second circuit board 30 and the flexible circuit board 40, to reduce an occupied area of the first support member 51 in a plane perpendicular to the arrangement direction Z, thereby increasing an element arrangement space between the second circuit board 30 and the flexible circuit board 40.

It may be understood that, in another embodiment, the first support member 51 may alternatively extend in a direction inclined relative to the arrangement direction Z, and the first connection portion 31 and the second connection portion 401 may also be arranged in a direction inclined relative to the arrangement direction Z. For example, an orthographic projection of the first connection portion 31 on the second circuit board in the arrangement direction Z is spaced from the second connection portion 401.

In an embodiment, the flexible circuit board 40 is connected to the first support member 51, then crosses the junction 1001 between the first cavity 101 and the second cavity 103, and continues to extend along the cavity wall 1011 of the first cavity 101. However, this is not limited thereto.

It may be understood that, in another embodiment, the flexible circuit board 40 may alternatively not pass the junction 1001 between the first cavity 101 and the second cavity 103. For example, the flexible circuit board 40 is connected to the first support member 51 and then extends to a side of the second cavity 103 in the arrangement direction Z.

By using the first support member 51, the first flexible circuit board 40 and the second circuit board 30 have the spacing in the arrangement direction Z. The flexible circuit board 40 is supported by the first support member 51 in a direction of the second cavity 103 toward the first cavity 101. The flexible circuit board 40 may be located in the first cavity 101 outside the second cavity 103. Alternatively, the second connection portion 401 of the flexible circuit board 40 is located in the second cavity 103 and partially extends into the first cavity 101 to be connected to the first circuit board 20.

When the entire flexible circuit board 40 is located in the first cavity 101, the second connection portion 401 of the flexible circuit board 40 is located outside the second cavity 103. When the flexible circuit board 40 is connected to the second circuit board 30 in the second cavity 103 and continues to extend along the cavity wall 1011 of the first cavity 101, a slope-climbing section is not needed when the flexible circuit board 40 extends from the second cavity 103 to the first cavity 101 and cross the junction 1001, thereby avoiding a wall-climbing problem of the flexible circuit board 40. When slope-climbing is not needed for the flexible circuit board 40, under support of the first support member 51, soldering stability between the second connection portion 401 and the first support member 51 is improved, and a tearing risk of the second connection portion 401 and the first support member 51 in an assembly process is reduced.

When the second connection portion 401 is connected to the first support member 51 in the second cavity 103, the first support member 51 elevates a position of the flexible circuit board 40 in the second cavity 103 in the arrangement direction Z, to reduce a distance between the cavity wall 1011 of the first cavity 101 and the second connection portion 401, thereby reducing a wall-climbing height of the flexible circuit board 40 extending from the second cavity 103 to the first cavity 101. This avoids a large size difference of the flexible circuit board 40 in the arrangement direction Z, for example, a size difference greater than 0.6 mm.

In an embodiment, the first support member 51 is a circuit board structure. A plurality of soldering holes 513 are separately disposed on two opposite sides of the first support member 51 in the arrangement direction Z. The soldering hole 513 is a through-hole structure. The soldering hole 513 is filled with solder. The first support member 51 is provided with a pad 511 on a peripheral side of the through hole formed by using a through-hole machine. The pad 511 is connected to the second connection portion 401 in a manner of laser beam welding, hotbar (Hotbar) soldering, or the like, to improve soldering strength of the flexible circuit board 40. The pad 511 is soldered to the first connection portion 31 of the second circuit board 30 in a reflow soldering manner or the like.

In another embodiment, as shown in FIG. 7, in a wearable device 100a, the first support member 51 is designed in a high density interconnector (High Density Interconnector, HDI) manner, and a soldering hole 513a is a hole structure formed by communicating a buried via hole with two blind via holes. A manner of soldering the first support member 51 to the flexible circuit board 40 and the second circuit board 30 needs to be set according to a requirement.

It may be understood that, in another embodiment, the first support member 51 may alternatively be a plastic structure (not shown in the figure) embedded with a metal structure (not shown in the figure), where the metal structure serves as a pad of the first support member. The metal structure and the plastic structure may be formed integrally.

In an embodiment, the wearable device 100 further includes a plurality of first elements 61. The plurality of first elements 61 are separately connected to the flexible circuit board 40 and are located on a side that is of the flexible circuit board 40 and that faces the second circuit board 30. The first support member 51 is supported between the flexible circuit board 40 and the second circuit board 30, to increase a space between the flexible circuit board 40 and the second circuit board 30. In addition, the first support member 51 is at least partially located in the second cavity 103. The plurality of first elements 61 can use this part of space to reduce or avoid a case in which the plurality of first elements 61 of the flexible circuit board 40 occupy a space of the first cavity 101, thereby avoiding an increase of the size of the entire wearable device 100 in the arrangement direction Z.

In an embodiment, the wearable device 100 further includes a plurality of second elements 62. The plurality of second elements 62 are disposed on the second circuit board 30, and are located on a side that is of the circuit board 205 and that faces the flexible circuit board 40. The plurality of first elements 61 and the plurality of second elements 62 are disposed opposite to each other and are interleaved between the flexible circuit board 40 and the second circuit board 30. To be specific, the plurality of first elements 61 and the plurality of second elements 62 extend in the arrangement direction Z toward each other, and projections of each first element 61 and each second element 62 on the second circuit board 30 in the arrangement direction Z do not overlap.

The plurality of first elements 61 and the plurality of second elements 62 are disposed in a space formed between the flexible circuit board 40 and the second circuit board 30 that are supported by the first support member 51, to reduce a space occupied in the first cavity 101 in the arrangement direction Z, thereby effectively reducing a size of the wearable device 100 in the arrangement direction Z.

In an embodiment, a spacing between the flexible circuit board 40 and the second circuit board 30 in the arrangement direction Z is less than a sum of a maximum size of the plurality of first elements 61 in the arrangement direction Z and a minimum size of the plurality of second elements 62 in the arrangement direction Z. In other words, a first element 61 having the maximum size in the arrangement direction Z is not superposed on any second element 62 in the arrangement direction Z. In this way, the spacing between the flexible circuit board 40 and the second circuit board 30 is as small as possible.

In an embodiment, a spacing between the flexible circuit board 40 and the second circuit board 30 in the arrangement direction Z is less than a sum of a maximum size of the plurality of second elements 62 in the arrangement direction Z and a minimum value of the plurality of first elements 61 in the arrangement direction Z. In other words, a second element 62 having the maximum size in the arrangement direction Z is not superposed on any first element 61 in the arrangement direction Z. In this way, the spacing between the flexible circuit board 40 and the second circuit board 30 is as small as possible.

It may be understood that, in another embodiment, a spacing between the flexible circuit board 40 and the second circuit board 30 in the arrangement direction Z may alternatively be greater than or equal to a sum of a maximum size of the plurality of first elements 61 in the arrangement direction Z and a minimum size of the plurality of second elements 62 in the arrangement direction Z, or greater than a sum of a maximum size of the plurality of first elements 61 in the arrangement direction Z and a minimum size of the plurality of second elements 62 in the arrangement direction Z. For example, in another embodiment, when a sum of a maximum size of the plurality of first elements 61 in the arrangement direction Z and a minimum size of the plurality of second elements 62 in the arrangement direction Z is less than the sum of the maximum size of the plurality of first elements 61 in the arrangement direction Z and the minimum size of the plurality of second elements 62 in the arrangement direction Z, a spacing between the flexible circuit board 40 and the second circuit board 30 in the arrangement direction Z is greater than the sum of the maximum size of the plurality of first elements 61 in the arrangement direction Z and the minimum size of the plurality of second elements 62 in the arrangement direction Z, and is less than the sum of the maximum size of the plurality of first elements 61 in the arrangement direction Z and the minimum size of the plurality of second elements 62 in the arrangement direction Z.

Projections of each of the plurality of first elements 61 and each of the plurality of second elements 62 on the second circuit board 30 do not overlap. This avoids superposition of sizes of the first element 61 and the second element 62 in the arrangement direction Z, and further effectively reduces the size of the wearable device 100 in the arrangement direction Z.

The first element 61 and the second element 62 each may be one of modules such as a chip, a radio link control (Radio Link Control, RLC) circuit module, a photoplethysmography (Photoplethysmography, PPG) circuit module, an AFE (Active Front End) circuit module, an electrocardiogram (electrocardiogram, ECG) circuit module, a charging load switch module, and a charging protection circuit.

A size of the first support member 51 in the arrangement direction Z may be set based on the maximum size of the plurality of first elements 61 and the plurality of second elements 62 that are connected between the flexible circuit board 40 and the second circuit board 30 in the arrangement direction Z.

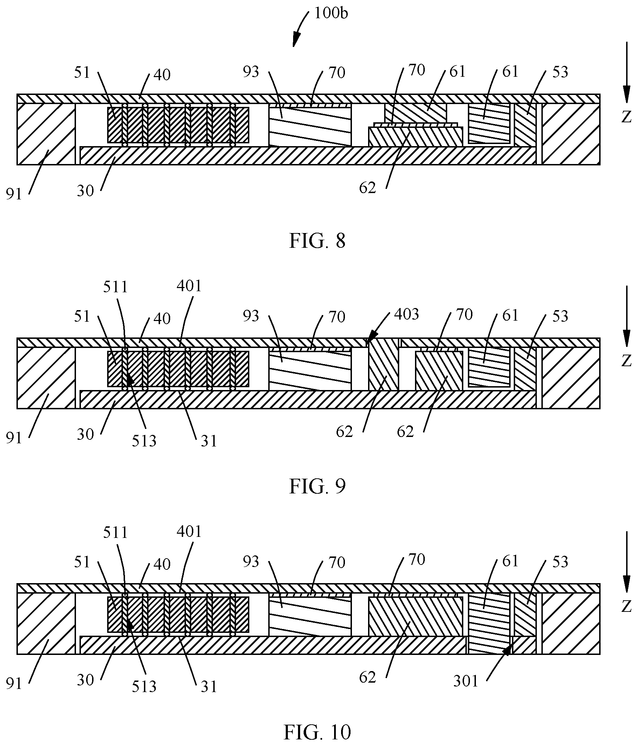

If it is unnecessary to solder a module to the second circuit board 30, the module may be soldered to the flexible circuit board 40 as a first element 61, to reduce a quantity of soldered dots of the second circuit board 30 and improve space utilization between the second circuit board 30 and the flexible circuit board 40. For example, in another embodiment, as shown in FIG. 8, in a wearable device 100b, a sum of sizes of one of the plurality of first elements 61 and one of the plurality of second elements 62 in the arrangement direction Z is n, and a maximum size of the plurality of first elements 61 and the plurality of second elements 62 in the arrangement direction Z is m. Because n is less than m, and m is less than the spacing between the flexible circuit board 40 and the second circuit board 30 in the arrangement direction Z, projections of the first element 61 and the second element 62 on the second circuit board 30 intersect. In other words, the first element 61 and the second element 62 face each other in the arrangement direction Z, and the two elements are disposed in a superposition manner in the arrangement direction Z to reduce an occupied area in a plane perpendicular to a thickness space, to fully use a space of the second circuit board 30 and the flexible circuit board 40 in the arrangement direction Z, thereby reducing areas of the second circuit board 30 and the second cavity 103 in a direction perpendicular to the arrangement direction Z.

Still with reference to FIG. 4 and FIG. 6, in an embodiment, the wearable device 100 further includes a battery 80. The battery 80 is disposed in the first cavity 101. The battery 80 is located between the first circuit board 20 and the second circuit board 30 in the arrangement direction Z. However, this is not limited thereto. The battery 80, the flexible circuit board 40, and the second circuit board 30 are arranged in the arrangement direction Z. When the first elements 61 are located between the flexible circuit board 40 and the second circuit board 30, the battery 80 is located on a side that is of the flexible circuit board 40 and that faces away from the plurality of first elements 61. In other words, the side that is of the flexible circuit board 40 and that faces away from the plurality of first elements 61 faces the battery 80. The plurality of first elements 61 are separated from the battery 80 by the flexible circuit board 40, to avoid damage caused due to collision with the battery 80 when the first elements 61 are separated from the flexible circuit board 40 by external force, thereby protecting the battery 80 and the first elements 61 and improving safety of the battery 80.

It may be understood that, in another embodiment, the battery 80 may alternatively be located between the first circuit board 20 and the screen 13.

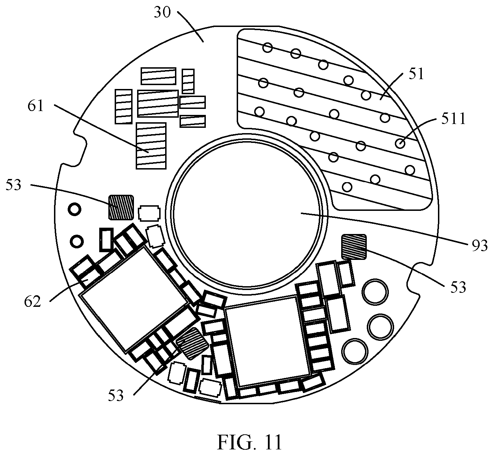

In an embodiment, with reference to FIG. 11, the second circuit board 30 is a circular plate structure, and the second cavity 103 is approximately a cylindrical cavity structure adapted to the second circuit board 30. However, this is not limited thereto. For example, in another embodiment, the second circuit board 30 may alternatively be a plate structure of another shape such as a rectangle or an oval. The second cavity 103 may alternatively be a cavity structure of another shape that can accommodate the second circuit board 30.

In an embodiment, the flexible circuit board 40 includes a first section 41, a second section 43, and a third section 45 that are connected in sequence. The second section 43 is electrically connected to the first circuit board 20 by using the third section 45. The second connection portion 401 is disposed on the first section 41. The first section 41 and the third section 45 are respectively located on two opposite sides of the battery 80 in the arrangement direction Z. The third section 45 is connected to the first circuit board 20. The flexible circuit board 40 bypasses the battery 80 and is connected to the first circuit board 20, so that the first circuit board 20 and the battery 80 are laid in the arrangement direction Z, thereby improving layout rationalization in the first cavity 101 of the wearable device 100. The first section 41 is flat, to avoid a wall-climbing problem caused due to bent extension of the first section 41 between the first cavity 101 and the second cavity 103. The first section 41 of the flexible circuit board 40 is flat, thereby facilitating reduction of a space occupied by the first section 41 of the flexible circuit board 40 on a side that is of the battery 80 and that is away from the first circuit board 20 in the arrangement direction Z.

In an embodiment, the second section 43 is perpendicular to the first section 41 and the third section 45. However, this is not limited thereto.

It may be understood that in another embodiment, the third section 45 may alternatively be omitted, and the second section 43 is bent relative to the first section 41 and then is connected to the first circuit board 20.

The conventional technology is shown in FIG. 3. Because the flexible circuit board 40 climbs a distance in the arrangement direction Z on an edge of the circuit board 205, and the circuit board 205 is a circular plate structure, a wall-climbing start section of the flexible circuit board 40 is a straight line, and the straight line is parallel to a chord of a reference circle of a circular outline of the circuit board 205. As a result, a soldering position cannot be disposed on the circuit board 205 at a position between a minor arc and a chord, reducing layout density of the circuit board 205.

In an embodiment, with reference to FIG. 4, FIG. 6, and FIG. 9, compared with the wearable device 100 in the conventional technology, the flexible circuit board 40 has no wall-climbing section near the second connection portion 401. Projections of a plurality of pads 511 of the first support member 51 on the second circuit board 30 in the arrangement direction Z can be laid at positions near the edge of the second circuit board 30, to improve density of soldering positions laid on the second circuit board 30, thereby facilitating reduction of a size of the second circuit board 30.

It may be understood that, in another embodiment, projections of the first support member 51 and the second connection portion 401 on the second circuit board 30 in the arrangement direction Z may alternatively be located at other positions, for example, positions near a center of the second circuit board 30.

In an embodiment, the first support member 51 is located near an edge that is of the second circuit board 30 and that is near the second section 43 of the flexible circuit board 40. However, this is not limited thereto.

To improve spatial stability between the flexible circuit board 40 and the second circuit board 30, the wearable device 100 further includes a second support member 53. The second support member 53 is connected to the second circuit board 30 and is supported between the flexible circuit board 40 and the second circuit board 30. The second support member 53 and the first support member 51 are spaced and are separately near an edge of the second circuit board 30.

It may be understood that, in another embodiment, the first support member 51 and the second support member 53 may be respectively located at other positions. For example, the first support member 51 and/or the second support member 53 are near the center of the second circuit board 30.

In an embodiment, there are one first support member 51 and one second support member 53. However, this is not limited thereto.

It may be understood that, in another embodiment, one end of the second support member 53 may alternatively be connected to the flexible circuit board 40, and the other end of the second support member 53 is ground connected to the second circuit board 30. Alternatively, two ends of the second support member 53 are respectively connected to the flexible circuit board 40 and the second circuit board 30.

In an embodiment, the second support member 53 is a metal member. However, this is not limited thereto. For example, in another embodiment, the second support member 53 is a plastic member.

The first support member 51 and the second support member 53 are spaced and supported between the second circuit board 30 and the flexible circuit board 40, to provide support force for the flexible circuit board 40 and the second circuit board 30 under external force, thereby improving space stability between the flexible circuit board 40 and the second circuit board 30 and improving reliability of disposing the plurality of first elements 61 and the plurality of second elements 62 in the space.

With reference to FIG. 4 and FIG. 6, in an embodiment, the wearable device 100 further includes a charging coil 91. The charging coil 91 is located in the second cavity 103 and surrounds an outer periphery of the plurality of first elements 61 and the plurality of second elements 62. The charging coil 91 is connected to the second circuit board 30. The charging coil 91 is located in the second cavity 103, and a size of the second circuit board 30 is reduced, so that a space for accommodating the charging coil 91 is reserved in the second cavity 103. The charging coil 91 does not occupy a size of the first cavity 101. In other words, the charging coil 91 does not increase the size of the first cavity 101 in the arrangement direction Z, thereby reducing visual heaviness of the wearable device 100.

In an embodiment, the charging coil 91 is bonded to the housing 10, that is, bonded to a bottom wall of the second cavity 103, thereby improving position stability of the charging coil 91. In an embodiment, the charging coil 91 and the flexible circuit board 40 are spaced. However, this is not limited thereto. For example, in another embodiment, the flexible circuit board 40 abuts against the charging coil 91, to further improve position stability of the charging coil 91.

It may be understood that, in another embodiment, the charging coil 91 may alternatively be located in the first cavity 101. For example, as shown in FIG. 1 of the conventional technology, the wearable device 100 further includes a middle shell 210. The middle shell 210 is connected to the housing 10. The charging coil 211 is sandwiched between the middle shell 210 and the housing 10 and is connected to the flexible circuit board 40. The middle shell 210 and the housing 10 fasten the charging coil 211 in a clamping manner with high stability.

It may be understood that, in another embodiment, the first element 61 and/or the second element 62 may be arranged on an outer periphery of the charging coil 91.

In an embodiment, the wearable device 100 further includes a magnet 93. The magnet 93 is disposed on the second circuit board 30 and is located in the second cavity 103. The magnet 93 is configured to absorb a charging device (not shown in the figure). Specifically, the magnet 93 and a magnetic suction structure (not shown in the figure) in the charging device adsorb each other, so that the charging device and the wearable device 100 are positioned relative to each other. The magnet 93 can position the wearable device 100 on the charging device, so that charging efficiency can be improved through cooperation between the charging coil 91 of the wearable device 100 and a coil of the charging device.

In an embodiment, the magnet 93 is located at the center of the second circuit board 30. However, this is not limited thereto. A position of the magnet 93 is set based on relative positions of the magnetic suction structure and the coil in the charging device, and a position of the charging coil 91.

In an embodiment, the magnet 93 is fastened to the second circuit board 30. The second circuit board 30 has higher hardness than the flexible circuit board 40 and is not prone to deformation. This facilitates position stability of the magnet 93 in the housing 10, and further improves positioning accuracy of the charging device and the wearable device 100.

It may be understood that, in another embodiment, the magnet 93 may alternatively be omitted.

With reference to FIG. 6, in an embodiment, the wearable device 100 further includes a plurality of connection pieces 70. There are two connection pieces 70. However, this is not limited thereto. One of the two connection pieces 70 is separately connected to the flexible circuit board 40 and the magnet 93 in the arrangement direction Z, and the other of the two connection pieces 70 is connected to the flexible circuit board 40 and the second element 62 in the arrangement direction Z, to improve connection reliability of the flexible circuit board 40 and the second connection piece 70 and reduce a motion amount of the flexible circuit board 40.

In an embodiment, the connection piece 70 is a back adhesive. However, this is not limited thereto.

One or more second elements 62 that are relatively large on a side facing the flexible circuit board 40 in a plane perpendicular to the arrangement direction Z may be selected from the plurality of second elements 62 disposed on the second circuit board 30 and are bonded to the connection piece 70, to improve connection reliability.

It may be understood that in another embodiment, the connection piece 70 may alternatively be bonded between the first element 61 and the second element 62, or the connection piece 70 may be bonded between the first element 61 and the second circuit board 30. In this way, an indirect connection may be implemented between the flexible circuit board 40 and the second circuit board 30. For example, as shown in FIG. 8, one of the two connection pieces 70 is connected between the flexible circuit board 40 and the second element 62, and the other of the two connection pieces 70 is connected between the first element 61 and the second element 62.

In an embodiment, a projection of the connection piece 70 on the flexible circuit board 40 in the arrangement direction Z approximately corresponds to the first section 41. A size of the connection piece 70 and/or the magnet 93 in the arrangement direction Z is adjustable, so that the first section 41 of the flexible circuit board 40 is in a stable flat state, to increase a wiring area of the flexible circuit board 40.

With reference to FIG. 9, in another embodiment, the flexible circuit board 40 is provided with a first accommodating hole 403, and the first accommodating hole 403 penetrates the flexible circuit board 40 in the arrangement direction Z. The second element 62 is partially accommodated in the first accommodating hole 403.

In an embodiment, one end that is of the second element 62 and that is away from the second circuit board 30 is located in the first accommodating hole 403, and does not protrude from a side that is of the flexible circuit board 40 and that is away from the second circuit board 30.

The first accommodating hole 403 accommodates a part of the second element 62, so that the spacing between the second circuit board 30 and the flexible circuit board 40 is less than a size of the second element 62 in the arrangement direction Z, to facilitate reduction of the overall size of the wearable device 100 in the arrangement direction Z.

It may be understood that, in another embodiment, the first accommodating hole 403 may alternatively be a blind via hole structure, and the flexible circuit board 40 isolates the second element 62 from a structure (for example, the battery 80) located on a side that is of the flexible circuit board 40 and that faces away from the second circuit board 30.

It may be understood that, in another embodiment, one end of the second element 62 may pass through the first accommodating hole 403 and then protrude from the side that is of the flexible circuit board 40 and that faces away from the second circuit board 30.

With reference to FIG. 10, in still another embodiment, the second circuit board 30 is provided with a second accommodating hole 301. The second accommodating hole 301 penetrates the second circuit board 30 in the arrangement direction Z. However, this is not limited thereto.

In an embodiment, one end that is of the first element 61 and that is away from the flexible circuit board 40 is located in the second accommodating hole 301 and does not protrude from the side that is of the second circuit board 30 and that faces away from the flexible circuit board 40.

The second accommodating hole 301 accommodates a part of the first element 61, so that the spacing between the second circuit board 30 and the flexible circuit board 40 is less than a size of the first element 61 in the arrangement direction Z, to facilitate reduction of the overall size of the wearable device 100 in the arrangement direction Z.

It may be understood that, in another embodiment, the second accommodating hole 301 may alternatively be a blind via hole structure.

It may be understood that, in another embodiment, one end of the first element 61 may pass through the second accommodating hole 301 and then protrude from a side that is of the second circuit board 30 and that faces away from the flexible circuit board 40.

With reference to FIG. 5, in an embodiment, the flexible circuit board 40 further includes a plurality of fourth sections 47. The plurality of fourth sections 47 are separately connected to the first section 41 and extend to a peripheral side of the second cavity 103. The wearable device 100 further includes a plurality of third elements 63. The plurality of third elements 63 are separately disposed in the first cavity 101 and are located on an outer peripheral side of the second cavity 103. Each fourth section 47 is connected to one or more third elements 63. The plurality of third elements 63 each may be a motor, a grounding module, a MIC module, a barometer, or the like.

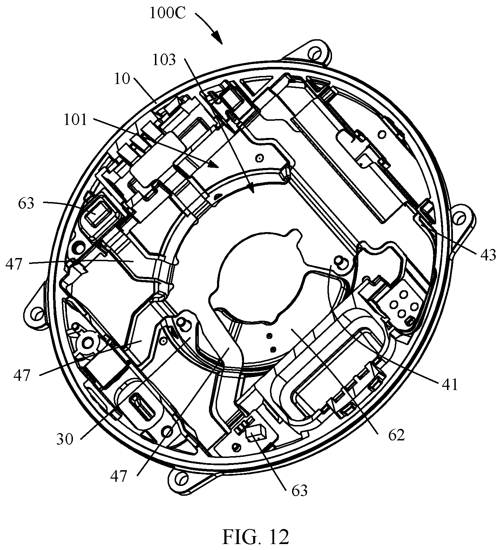

In another embodiment, as shown in FIG. 12, in a wearable device 100c, the first section 41 and the fourth section 47 are in a non-flat state, and the first support member 51 elevates a position of the flexible circuit board 40 relative to the second cavity 103 in the arrangement direction Z, to reduce a wall-climbing height of the fourth section 47 of the flexible circuit board 40 connected to the third element 63 and reduce a wall-climbing height of the first section 41, thereby further reducing motion ranges of the fourth section 47 and the first section 41 and reducing risks such as wrinkling caused due to motion of the fourth section 47 and the first section 41 under force.

In the foregoing wearable device 100, when the flexible circuit board 40 is connected to the first circuit board 20 in the first cavity 101, a slope-climbing section is not needed when the flexible circuit board 40 extends from the second cavity 103 to the first cavity 101, thereby avoiding a wall-climbing problem of the flexible circuit board 40. Alternatively, the first support member 51 elevates a position of the second connection portion 401 of the flexible circuit board 40 in the second cavity 103 in the arrangement direction Z, to reduce a distance between the second connection portion 401 and the cavity wall that is of the first cavity 101 and that faces the second cavity 103, thereby reducing a wall-climbing height of the flexible circuit board 40 extending from the second cavity 103 to the first cavity 101 and avoiding a large size difference of the flexible circuit board 40 in the arrangement direction Z.

In addition, those of ordinary skill in the art should be aware of that the foregoing embodiments are only intended to describe this application, but not to limit this application. Appropriate modifications and variations made to the foregoing embodiments without departing from the essential spirit and scope of this application all fall within the scope of this application.

## Claims

1. A wearable device, comprising:
a housing, provided with a first cavity and a second cavity that are arranged in sequence and communicate with each other;
a first circuit board, disposed in the first cavity;
a second circuit board, disposed in the second cavity and provided with a first connection portion; and
a flexible circuit board, connected to and electrically conductive to the first circuit board, wherein the flexible circuit board is provided with a second connection portion, and the wearable device further comprises:
a first support member, connected between the first connection portion and the second connection portion, so that the second circuit board and the flexible circuit board are electrically conductive and have a spacing in an arrangement direction of the second cavity and the first cavity.

2. The wearable device according to claim 1, wherein the wearable device further comprises:
a plurality of first elements, separately connected to a side that is of the flexible circuit board and that faces the second circuit board; and
a plurality of second elements, separately connected to a side that is of the second circuit board and that faces the flexible circuit board.

3. The wearable device according to claim 2, wherein the spacing between the flexible circuit board and the second circuit board in the arrangement direction is less than a sum of a maximum size of the plurality of first elements in the arrangement direction and a minimum size of the plurality of second elements in the arrangement direction; and/or
the spacing between the flexible circuit board and the second circuit board in the arrangement direction is less than a sum of a minimum size of the plurality of first elements in the arrangement direction and a maximum size of the plurality of second elements in the arrangement direction; and/or
when a sum of sizes of the first element and the second element in the arrangement direction is less than the spacing between the flexible circuit board and the second circuit board, projections of the first element and the second element on the second circuit board in the arrangement direction intersect.

4. The wearable device according to claim 2, wherein the wearable device further comprises a connection piece;
projections of the first element and the second element on the second circuit board in the arrangement direction intersect, and the connection piece is bonded between the first element and the second element; and/or
the connection piece is bonded between the first element and the second circuit board; and/or
the connection piece is bonded between the second element and the flexible circuit board.

5. The wearable device according to any one of claims 2 to 4, wherein the wearable device further comprises a battery, the battery is disposed in the first cavity, and the battery, the flexible circuit board, and the second circuit board are arranged in the arrangement direction.

6. The wearable device according to any one of claims 2 to 4, wherein the flexible circuit board is provided with a first accommodating hole, and a part of the second element is accommodated in the first accommodating hole; and/or
the second circuit board is provided with a second accommodating hole, and a part of the first element is accommodated in the second accommodating hole.

7. The wearable device according to any one of claims 1 to 4, wherein the flexible circuit board comprises a first section and a second section that are connected in sequence; and
the second section extends toward a side of the first section, so that the second section is connected to the first circuit board; and the second connection portion is disposed on the first section, and the first section is flat.

8. The wearable device according to any one of claims 1 to 4, wherein the flexible circuit board comprises a first section and a second section that are connected in sequence, and the second section extends toward a side of the first section, so that the second section is connected to the first circuit board; and the second connection portion is disposed on the first section; and
the flexible circuit board further comprises a plurality of fourth sections, and the fourth sections are connected to the first section and separately extend to a peripheral side of the second cavity; and the wearable device further comprises a plurality of third elements, the plurality of third elements are separately disposed in the first cavity and are located on an outer peripheral side of the second cavity, and each fourth section is connected to at least one third element.

9. The wearable device according to any one of claims 1 to 4, wherein the first support member extends in the arrangement direction and is perpendicular to the first connection portion and the second connection portion.

10. The wearable device according to any one of claims 1 to 4, wherein the wearable device further comprises a charging coil, and the charging coil is located in the second cavity and is connected to the second circuit board or the flexible circuit board.

11. The wearable device according to claim 10, wherein the wearable device further comprises a magnet, the magnet is disposed on the second circuit board and is located in the second cavity, and the magnet is configured to absorb a charging device.

12. The wearable device according to any one of claims 1 to 4, wherein the wearable device further comprises a second support member, the second support member is connected to the flexible circuit board or the second circuit board and is supported between the flexible circuit board and the second circuit board; and
the second support member and the first support member are spaced.

13. The wearable device according to any one of claims 1 to 4, wherein a plurality of pads are separately disposed on two sides of the first support member, projections of the plurality of pads on the second circuit board in the arrangement direction are near an edge of the second circuit board, and the plurality of pads are separately soldered to the second connection portion and the second circuit board.
